# EUROPEAN PATENT APPLICATION

(11) **EP 1 916 316 A1**
(43) Date of publication of application: **30.04.2008**
(21) Application number: 06782842.6
(22) Date of filing: 15.08.2006
(51) Int. Cl.: C23C 18/31

(54) **ELECTROLESS PLATING APPARATUS AND PLATING LIQUID**

(30) Priority: 18.08.2005 JP 2005237894
(71) Applicant: EBARA CORPORATION LTD., Ohta-ku Tokyo 144 (JP)
(72) Inventor: SAIJO, Yasuhiko c/o Ebara Research Co., Ltd., Fujisawa-shi, Kanagawa 2518502 (JP); KOBA, Takashi c/o Ebara Corporation, Tokyo 1448510 (JP); TSUJINO, Junichiro c/o Ebara Corporation, Tokyo 1448510 (JP)
(74) Representative: Wagner & Geyer
(86) International application number: PCT/JP2006/316287
(87) International publication number: WO 2007/021023

(57) **Abstract**

An electroless plating apparatus (16) can suppress a change in quality of a plating solution and form a plated film without loss of its properties and reliability. The electroless plating apparatus (16) includes a plating solution circulation system (350) having a plating solution supply pipe (308) for supplying a plating solution in a plating solution reservoir tank(302) to a plating tank (200) and a plating solution recovery pipe (310) for returning the plating solution in the plating tank(200) to the plating solution reservoir tank(302), and a heat retention section (272a,272b,352,356) for preventing lowering of the temperature of the plating solution in the entire plating solution circulation system(350).

## Description

### Technical Field

The present invention relates to an electroless plating apparatus and a plating solution, and more particularly to an electroless plating apparatus used for forming, on bottom surfaces and side surfaces or exposed surfaces of embedded interconnects which have been formed by embedding an interconnect material (conductive material), such as copper or silver, into fine interconnect recesses provided in a surface of a substrate such as a semiconductor wafer, a conductive film having a function to prevent thermal diffusion of the interconnect material into an interlevel dielectric layer or a function to improve adhesiveness between the interconnects and an interlevel dielectric layer, or a protective film, such as magnetic film, covering interconnects, and a plating solution.

### Background Art

As an interconnect formation process for semiconductor devices, there is getting employed a process (so-called damascene process) in which interconnect material (conductive material) is embedded into interconnect.recesses such as trenches and contact holes. This process includes embedding aluminum or, recently, metal, such as copper or silver, or its alloy into trenches and contact holes (interconnect recesses), which have previously been formed in an interlevel dielectric layer, and then removing extra metal by chemical mechanical polishing (CMP) so as to flatten a surface of the substrate.

Conventionally, in a case of such interconnects, for example, copper interconnects, whichuse copper as an interconnectmaterial, there has been employed a method in which a barrier layer is formed on bottom surfaces and side surfaces of the interconnects to prevent thermal diffusion of the interconnects (copper) into an interlevel dielectric layer and to improve electromigration resistance of the interconnects so as to improve the reliability, or a method in which an anti-oxidizing film is formed to prevent oxidation of the interconnects (copper) under an oxidizing atmosphere so as to produce a semiconductor device having a multi-level interconnect structure in which insulating films (oxide films) are subsequently laminated. Generally, metal such as tantalum, titanium, or tungsten, or ruthenium, or nitride thereof has heretofore been used as this type of barrier layer. Nitride or carbide of silicon has generally been used as an anti-oxidizing film.

As an alternative or additional method of the above methods, there has been studied a method in which bottom surfaces and side surfaces or exposed surfaces of embedded interconnects are selectively covered with an protective filmmade of a cobalt alloy, a nickel alloy, or the like, to prevent thermal diffusion, electromigration, and oxidation of the interconnects. With regard to a non-volatile magnetic memory, it has been proposed that portions around memory interconnects are covered with a magnetic film such as a cobalt alloy or a nickel alloy in order to prevent a writing current from increasing due to miniaturization. For example, a cobalt alloy, a nickel alloy, and the like, are obtained by electroless plating.

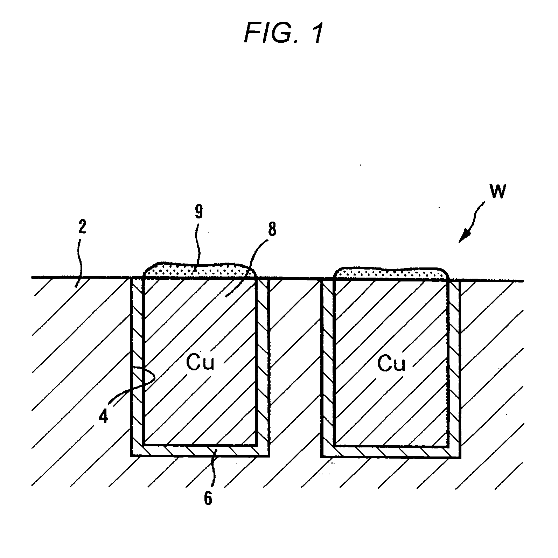

For example, as shown in FIG. 1, fine interconnect recesses 4 are formed in an insulating film (interlevel dielectric layer) 2 made of SiO₂ or the like, which has been deposited on a surface of a substrate W such as a semiconductor wafer. A barrier layer 6 of TaN or the like is formed on a surface of the insulating film, and then, for example, copper plating is carried out to deposit a copper film on the surface of the substrate W so as to embed copper in the interconnect recesses 4. Thereafter, CMP (chemical mechanical polishing) is carried out on the surface of the substrate W to planarize the surface, thereby forming interconnects 8 made of copper in the insulating film 2. A protective film (cap material) 9 of a CoWP alloy, which is obtained, for example, by electroless plating, is formed selectively on surfaces of the interconnects (copper film) 8 so as to protect the interconnects 8. The present invention, of course, is not limited to such a method.

There will be described a process of forming a protective film (cap material) 9 of such a CoWP alloy film selectively on surfaces of interconnects 8 by using a conventional electroless plating method. First, the substrate W such as a semiconductor wafer, which has been carried out a CMP process, is immersed, for example, in dilute sulfuric acid having an ordinary temperature for about one minute to remove an oxide film on surfaces of interconnects 8 and CMP residues such as of copper remaining on a surface of an insulating film 2 and the like. After the surface of the substrate W is cleaned (rinsed) with a cleaning liquid such as pure water, the substrate W is immersed, for example, in a PdCl₂/HCl mixed solution having an ordinary temperature for about one minute to adhere Pd as a catalyst to the surfaces of the interconnects 8 so as to activate exposed surfaces of the interconnects 8.

After the surface of the substrate W is cleaned (rinsed) with pure water or the like, the substrate W is immersed, for example, in a CoWP plating solution at the solution temperature of 80°C for about 120 seconds to carry out electroless plating (electroless CoWP cap plating) selectively on surfaces of the activated interconnects 8. Thereafter, the surface of the substrate W is cleaned with a cleaning liquid such as pure water. Thus, a protective film 9 made of a CoWP alloy is formed selectively on the exposed surfaces of interconnects 8 so as to protect interconnects 8.

### Disclosure of Invention

When an electroless plating process for forming a protective film selectively on the exposed surfaces of embedded interconnects is added to a manufacturing line of a semiconductor device, the cost of the process is desirably as low as possible. With regard to an electroless plating process, the depreciation and the cost of chemicals generally make up a substantial portion of the total cost with little cost of consumables. The depreciation can be reduced by increasing the throughput, and the chemical cost can be reduced by increasing the number of processed substrates per unit amount of chemical. However, when forming by electroless plating a plated film (protective film) of a CoWP alloy or the like on the surfaces of copper interconnects in the above-described manner, close attention should be paid to the reactivityof a plating solution in order to form a high-quality and uniform plated film and to precisely control a thickness of the plated film.

A plating solution for use in electroless plating generally has a composition of various types of chemical species. A deviation of any of the balance of the composition, the pH and the temperature of a plating solution from a standard will greatly change the quality of a plated film formed by electroless plating, the reaction rate, the latent time before initiation of the plating reaction, etc. A high level of technology and know-how is therefore required for control of such parameters. For example, when phosphinic acid is used to deposit cobalt, the temperature and the pH of the plating solution used should be made high. The use of a high temperature and a high pH, however, makes the plating solution unstable. The reactivity of a plating solution can change with time even when it is not actuallyused inplatingbut circulated within an apparatus, which could make it unable to carry out plating at all in the worst case.

On the other hand, in order to form a high-quality and uniform plated film while using a chemical solution (plating solution) in a circulatory manner for the purpose of reducing the chemical cost, it is necessary to use an apparatus for controlling the compositional balance of chemical species in the plating solution. Also in the case of using a small amount of plating solution per substrate in order to reduce the chemical cost, an apparatus, e.g., for in situ preparation of the plating solution will be necessary because the plating solution can change its quality even during circulation.

A low-cost introduction of an electroless plating process into a manufacturing line of a semiconductor device becomes possible only with a sufficient understanding of the influence of by-products produced by plating reaction, the limit time period for use of a plating solution, the limit number of processible substrates, an appropriate compositional balance of a plating solution, etc. In an actual plating process, a plating solution changes its quality in various manners depending on the operating conditions of the apparatus. Therefore, a decisive solution to the problem of quality change of plating solution has not been found as yet. Thus, clarification of the cause and the mechanism of change in quality of a plating solution is the biggest problem to be solved for using an electroless plating process in a manufacturing line of a semiconductor device.

The present invention has been made in view of the above situation. It is therefore an object of the present invention to provide an electroless plating apparatus and a plating solution which make it possible to suppress a change in quality of a plating solution and form a plated film without loss of its properties and reliability.

In order to achieve the above object, the present invention provides an electroless plating apparatus comprising: a plating solution circulation system including a plating solution supply pipe for supplying a plating solution in a plating solution reservoir tank to a plating tank, and a plating solution recovery pipe for returning the plating solution in the plating tank to the plating solution reservoir tank; and a heat retention section for preventing lowering of the temperature of the plating solution in the entire plating solution circulation system.

The present inventors, in carrying out experimental electroless plating under various conditions, have found that the change in quality of a plating solution is promoted by a repetition of rise and fall in the temperature of the plating solution. This phenomenon is not limited to a plating solution for forming a protective film. Thus, prevention of rise and fall in the temperature of a plating solution leads to stabilization and prolonged life of a variety of plating solution used in electroless plating, and enables a reduction in the chemical cost of any electroless plating process.

It has also been found by investigation of the cause of this phenomenon that the phenomenon is caused by a difference in temperature dependency of pH between chemicals used in a plating solution. A plating solution for use in electroless plating contains a complexing agent so that a metal ion will not precipitate as a hydroxide even when the pH of the plating solution is high. Further, a buffer is added to the plating solution in order to prevent a change in pH at a reaction surface due to a reaction of a reducing agent, such as phosphinic acid, and to grow a uniform plated film. The buffer shouldbe one which has a sufficient buffer capacity when the pH of the plating solution is adjusted to a predetermined value. The complex agent is an essential component, and is used in a concentration of at least equal to the concentration of a metal ion.

For example, when a plating solution contains citric acid, which is used as a complexing agent for complexing a cobalt ion, the pH of the plating solution increases as the temperature rises. On the other hand, when a plating solution contains boric acid, which is used as a buffer for a plating solution having a pH of about 9, the pH of the plating solution decreases as the temperature rises. When such components, whose temperature dependencies of pH are contradictory, are co-present in a plating solution, the pH of the plating solution changes with a change in the temperature of the plating solution. It is considered that the change in pH of the plating solution makes the plating solution unstable. This maywell account for the experimental knowledge that a rapid heating must be avoided in holding a plating solution at a high temperature.

It is desirable that a heater, which may be used to bring a plating solution to a high temperature, be set at a temperature which is as close to the temperature of the plating solution as possible. If the plating solution could be kept at a high temperature, it means that the same amount of heat as added to the plating solution by heating is to be released or lost somewhere, though the temperature is kept constant macroscopically.

According to the present invention, by preventing lowering of the temperature of a plating solution in the entire plating solution circulation system by the heat retention section, the plating solution can be kept at a more constant temperature while circulating it in the plating solution circulation system. This makes it possible to reduce a stress on the plating solution, which is produced upon a change in the temperature of the plating solution due to the presence of components having different temperature dependencies of pH, thereby extending the life of the plating solution, and to form a high-quality and uniform plated film at a low cost.

In a preferred aspect of the present invention, the heat retention section is comprised of a heat insulating material provided in substantially the entire area of the plating solution circulation system.

This can effectively prevent heat loss from a plating solution in the plating solution circulation system, thus keeping the plating solution at a more constant temperature over the entire plating solution circulation system.

Preferably, the heat retention section is provided in substantially the entire area of the plating solution recovery pipe.

This can effectively prevent lowering of the temperature of a plating solution due to heat loss from the plating solution as it flows in the plating solution recovery pipe from the plating tank to the plating solution reservoir tank. Thus, the plating solution can be kept at a higher temperature when it flows into a plating solution in the plating solution reservoir tank.

In a preferred aspect of the present invention, the heat retention section is comprised of a double pipe composed of the plating solution supply pipe as an inner pipe, and the plating solution recovery pipe as an outer pipe concentrically surrounding the plating solution supply pipe.

According to this structure, a plating solution flowing in the plating solution recovery pipe can be heated with a high-temperature plating solution flowing in the plating solution supply pipe while preventing heat loss from the plating solution flowing in the plating solution supply pipe.

The present invention provides another electroless plating apparatus comprising:a pure water replenishment pipe for supplying pure water to a plating solution in a plating solution reservoir tank storing the plating solution to be supplied to a plating tank; and a preheating section for preheating pure water to be supplied to the pure water replenishment pipe or pure water flowing along the pure water replenishment pipe.

Since a large amount of moisture evaporates from the high-temperature plating solution stored in the plating solution reservoir tank, the plating solution needs to be frequently replenished with pure water. By replenishing the plating solution in the plating solution reservoir tank with pure water which has been preheated to the temperature of the plating solution, according to the present invention, lowering of the temperature of the plating solution in the plating solution reservoir tank upon the supply of pure water can be prevented. Similarly, when replenishing the plating solution with a consumed component according to necessity, a replenisher solution containing the component is preferably preheated to the temperate of the plating solution.

In a preferred aspect of the present invention, a front end of the pure water replenishment pipe is connected to a heat exchange pipe disposed in the plating solution in the plating solution reservoir tank.

Even when the replenishing pure water falls in temperature, the pure water can be brought closer to the temperature of the plating solution in the plating solution reservoir tank upon its supply to the plating solution.

The present invention provides a plating solution comprising boric acid as a buffer and citric acid as a complexing agent, and having a temperature of 60 to 95°C, a pH of 7 to 9.8, and a boric acid concentration of 5 to 20 g/L in terms of orthoboric acid.

By using boric acid, which is used as a buffer to stabilize the pH of a plating solution at around 9, in a concentration of 5 to 20 g/L in terms of orthoboric acid (H₃BO₃) (in view of the solubility of borax of 2.67 g/100 g at 10°C and pH 9.8), preferably 10 to 15 g/L, e.g., in a plating solution for use in electroless plating to form a plated film (protective film) of a CoWP alloy, precipitation of borate crystals in the plating solution can be prevented while obtaining a sufficient buffer capacity.

In electroless plating, the plating rate is higher at a higher temperature of plating solution, and a plating reaction does not occur at a too low temperature. In view of this, the temperature of the present plating solution is preferably 65 to 85°C, more preferably 70 to 75°C.

Preferably, the plating solution of the present invention further comprises a cobalt ion in a concentration of 0.01 to 0.13 mol/L, and has a citric acid concentration of 0.1 to 0.5 mol /L.

The concentration of the cobalt ion is preferably 0.01 to 0.1 mol/L, more preferably 0.01 to 0.03 mol/L. In this regard, the use of a higher cobalt ion concentration necessitates a higher citric acid concentration. This requires the use of a higher concentration of an alkali or an equivalent ion for pH adjustment, which could cause unexpected precipitation of crystals.

The concentration of citric acid should be such as to sufficiently complex a metal ion, such as a cobalt ion, and be relatively high because citric acid is likely to be damaged by temperature stress. On the other hand, however, an alkali metal in an amount responding to the concentration of citric acid and the concentration of boric acid is needed in order to increase or adjust the pH of the plating solution. When the concentration of an alkali metal, especially sodium, is high, borax crystals are likely to precipitate due to the solubility product of sodium ion and borate ion, which could cause self-decomposition of the plating solution. In addition, the presence of a high concentration of alkali metal in the high-temperature, high-pH plating solution could cause dissolution of an oxide film. In view of the above, the concentration of citric acid is preferably 0.1 to 0.5 mol/L.

Preferably, the plating solution of the present invention further comprises phosphinic acid in a concentration of 0.1 to 0.5 mol/L and tungstic acid in a concentration of 0.004 to 0.1 mol/L in terms of tungsten.

The concentration of phosphinic acid, which not only affects the rate of plating reaction as a reducing agent, but is determinative of the P concentration of a plated film of, e.g., a CoWP alloy, is preferably 0.1 to 0.5 mol/L. The concentration of tungstic acid, which is not only determinative of the W concentration of a plated film of, e.g., a CoWP alloy, but affects the rate of plating reaction as well, is preferably 0.004 to 0.05 mol/L in terms of tungsten.

It becomes possible with the present invention to reduce a stress on a plating solution, which is produced upon a change in the temperature of the plating solution due to the presence of components having different temperature dependencies of pH, thereby extending the life of the plating solution, and to form a high-quality and uniform plated film, for example, a protective film selectively covering the exposed surfaces of low-resistance and highly-reliable copper interconnects, at a low cost.

### Brief Description of Drawings

FIG. 1 is a diagram showing an example for forming copper interconnects in a semiconductor device;
FIG. 2 is a layout plan view of a substrate processing apparatus incorporating an electroless plating apparatus according to an embodiment of the present invention;
FIG. 3 is a front view of a pre-processing apparatus omitting an outer tank at the time of substrate delivery;
FIG. 4 is a front view of the pre-processing apparatus omitting the outer tank at the time of processing with a processing liquid;
FIG. 5 is a front view of the pre-processing apparatus omitting the outer tank at the time of rinsing;
FIG. 6 is a cross-sectional view showing a processing head of the pre-processing apparatus at the time of substrate delivery;
FIG. 7 is an enlarged view of a portion A of FIG. 6;
FIG. 8 is a view of the pre-processing apparatus when the substrate is fixed, which corresponds to FIG. 7;
FIG. 9 is a system diagram of the pre-processing apparatus;
FIG. 10 is a cross-sectional view showing a substrate head of an electroless plating apparatus when a substrate is delivered;
FIG. 11 is an enlarged view of a portion B of FIG. 10;
FIG. 12 is a view of the substrate head of the electroless plating apparatus when the substrate is fixed, which corresponds to FIG. 11;
FIG. 13 is a view of the substrate head of the electroless plating apparatus at the time of plating, which corresponds to FIG. 11;
FIG. 14 is a front view showing, in a partially cutaway manner, a plating tank of the electroless plating apparatus when a plating tank cover is closed;
FIG. 15 is a cross-sectional view showing a cleaning tank of the electroless plating apparatus;
FIG. 16 is a system diagram of the electroless plating apparatus;
FIG. 17 is a front view showing, in a partially cutawaymanner, a pipe employed in a plating solution circulation system.
FIG. 18 is a front view showing, in a partially cutaway manner, another pipe employed as a plating solution supply pipe and a plating solution recovery pipe of the plating solution circulation system.
FIG. 19 is a plan view showing the post-processing apparatus;
FIG. 20 is a vertical cross-sectional view showing a drying apparatus;and
FIG. 21 is a schematic diagram showing an electroless plating apparatus according to another embodiment of the present invention.

### Best Mode for Carrying Out the Invention

An electroless plating apparatus according to an embodiment of the present invention will now be described with reference to the drawings. The following description illustrates a case of selectively covering exposed surfaces of interconnects 8 with a protective film (cap material) 9 of a CoWP alloy to protect interconnects 8, as shown in FIG. 1. The present invention may also be adapted to cover a surface of copper, silver or the like with a metal film by depositing the metal film (plated film) of a Co alloy, a Ni alloy or the like.

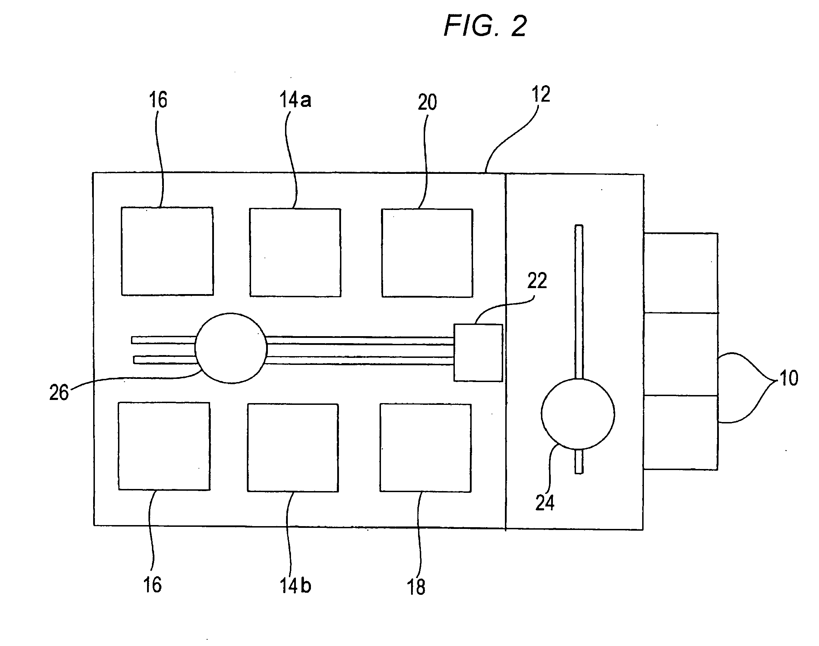

FIG. 2 is a layout plan view of a substrate processing apparatus incorporating an electroless plating apparatus according to an embodiment of the present invention. As shown in FIG. 2, the substrate processing apparatus is provided with loading/unloading units 10 each for mounting substrate cassette which accommodate a number of substrates W, such as semiconductor wafers, having interconnects 8 of, e. g. , copper on the surfaces. Inside of a rectangular apparatus frame 12 having an air discharge system, there are disposed a first pre-processing apparatus 14a for cleaning a surface of the substrate W with a cleaning liquid, and a second pre-processing apparatus 14b for imparting a catalyst, such as Pd, to a cleaned surface of the substrate. The first pre-processing apparatus 14a and the second pre-processing apparatus 14b use different processing liquids (chemical solutions) but have the same structure.

Inside of the apparatus frame 12, there are disposed two electroless plating apparatuses 16 for performing electroless plating onto a surface (surface to be processed) of the substrate W, a post-processing apparatus 18 for performing post-plating processing of the substrate W after the plating to improve the selectivityof a protective film (metal film) 9 formed on surfaces of interconnects 8 by electroless plating, a drying apparatus 20 for drying the substrate W after the post-processing, and a temporary storage table 22. Furthermore, inside of the apparatus frame 12, there are disposed a movable first substrate transport robot 24 for transferring a substrate between the substrate cassette set in the loading/unloading unit 10 and the temporary storage table 22, and a moveable second substrate transport robot 26 for transferring a substrate between the temporary storage table 22 and each of the apparatuses 14, 16, 18, and 20.

Next, there will be described below the details of various apparatuses provided in the substrate processing apparatus shown in FIG. 2.

The pre-processing apparatus 14a (14b) employs a two-liquid separation system to prevent the different liquids frombeingmixed with each other. While a peripheral portion of a lower surface of the substrate W, which is a surface to be processed (front face), transferred in a face-down manner is sealed, the substrate W is fixed by pressing a rear face of the substrate.

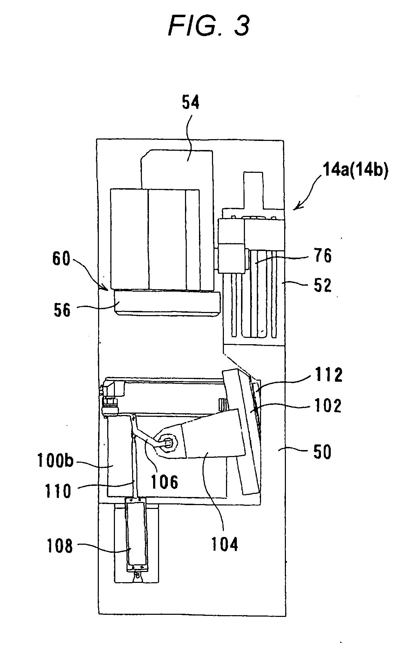

As shown in FIGS. 3 through 6, the pre-processing apparatus 14a (14b) includes a fixed frame 52 that is mounted on the upper part of a frame 50, and a movable frame 54 that moves up and down relative to the fixed frame 52. A processing head 60, which includes a bottomed cylindrical housing portion 56, opening downwardly, and a substrate holder 58, is suspended from and supported by the movable frame 54. In particular, a head-rotating servomotor 62 is mounted to the movable frame 54, and the housing portion 56 of the processing head 60 is coupled to the lower end of the downward-extending output shaft (hollow shaft) 64 of the servomotor 62.

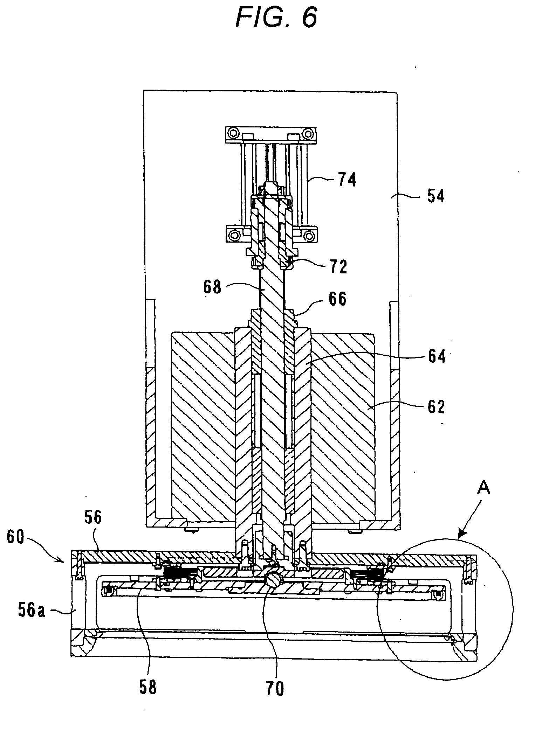

As shown in FIG. 6, a vertical shaft 68, which rotates together with the output shaft 64 via a spline 66, is inserted in the output shaft 64, and the substrate holder 58 of the processing head 60 is coupled to the lower end of the vertical shaft 68 via a ball joint 70. The substrate holder 58 is positioned within the housing portion 56. The upper end of the vertical shaft 68 is coupled via a bearing 72 and a bracket to a fixed ring-elevating cylinder 74 secured to the movable frame 54. Thus, by the actuation of the cylinder 74, the vertical shaft 68 moves vertically independently of the output shaft 64.

Linear guides 76, which extend vertically and guide vertical movement of the movable frame 54, are mounted to the fixed frame 52, so that by the actuation of a head-elevating cylinder (not shown), the movable frame 54 moves vertically by the guide of the linear guides 76.

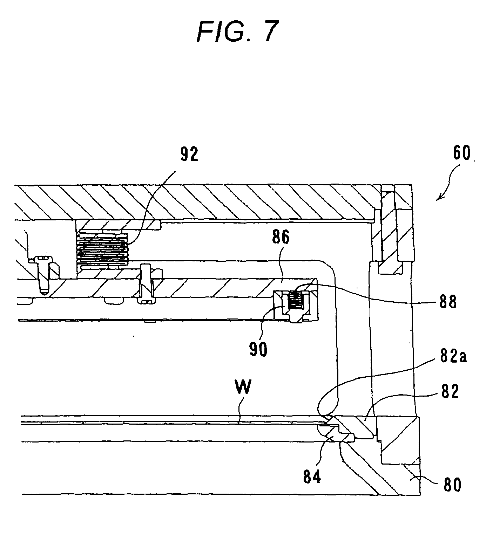

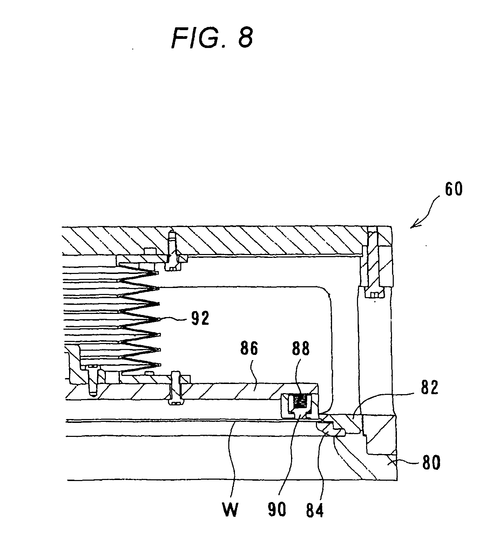

Substrate insertion windows 56a for inserting the substrate W into the housing portion 56 are formed in the circumferential wall of the housing portion 56 of the processing head 60. Further, as shown in FIGS. 7 and 8, a seal ring 84 is provided in the lower portion of the housing portion 56 of the processing head 60, an outer peripheral portion of the seal ring 84 being sandwiched between a main frame 80 made of, e.g., PEEK and a guide frame 82. The seal ring 84 is provided to make contact with a peripheral portionof the lower surface of the substrate W to seal the peripheral portion.

A substrate fixing ring 86 is fixed to a peripheral portion of the lower surface of the substrate holder 58. Columnar pushers 90 eachprotrudes downwardly from the lower surface of the substrate fixing ring 86 by the elastic force of a spring 88 disposed within the substrate fixing ring 86 of the substrate holder 58. Further, a flexible cylindrical bellows-like plate 92 made of, e.g., Teflon (registered trademark) is disposed between the upper surface of the substrate holder 58 and the upper wall of the housing portion 56 to hermetically seal therein. Further, the substrate holder 58 is provided with a covering plate 94 for covering an upper surface of the substrate held by the substrate holder 58.

When the substrate holder 58 is in a raised position, a substrate W is inserted from the substrate insertion window 56a into the housing portion 56. The substrate W is then guided by a tapered surface 82a provided in the inner circumferential surface of the guide frame 82, and positioned and placed at a predetermined position on the upper surface of the seal ring 84. In this state, the substrate holder 58 is lowered so as to bring the pushers 90 of the substrate fixing ring 86 into contact with the upper surface of the substrate W. The substrate holder 58 is further lowered so as to press the substrate W downwardly by the elastic forces of the springs 88, thereby forcing the seal ring 84 to make pressure contact with a peripheral portion of the front surface (lower surface) of the substrate W to seal the peripheral portion while nipping the substrate W between the housing portion 56 and the substrate holder 58 to hold the substrate W.

When the head-rotating servomotor 62 is driven while the substrate W is thus held by the substrate holder 58, the output shaft 64 and the vertical shaft 68 inserted in the output shaft 64 rotate together via the spline 66, whereby the substrate holder 58 rotates together with the housing portion 56.

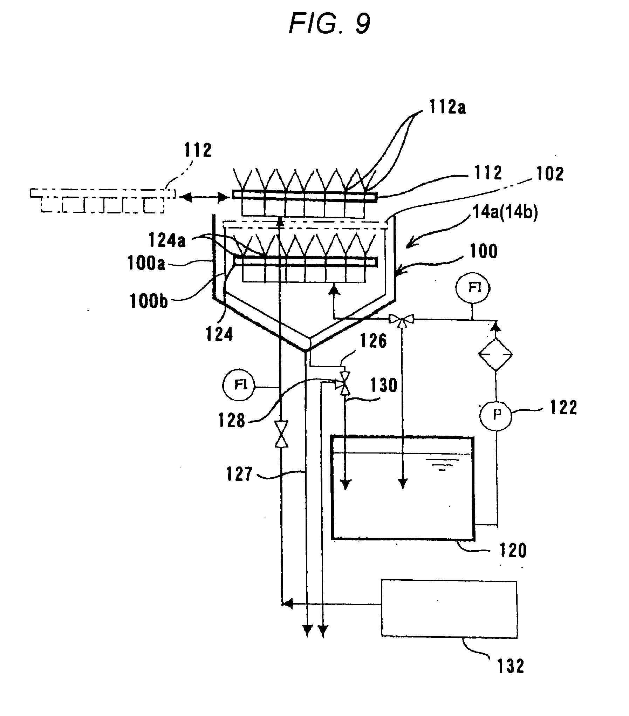

At a position below the processing head 60, there is provided an upward-open processing tank 100 (see FIG. 9) comprising an outer tank 100a and an inner tank 100b which have a slightly larger inner diameter than the outer diameter of the processing head 60. A pair of leg portions 104, which is mounted to a lid 102, is rotatably supported on the outer circumferential portion of the inner tank 100b. Further, a crank 106 is integrally coupled to each leg portion 106, and the free end of the crank 106 is rotatably coupled to the rod 110 of a lid-moving cylinder 108. Thus, by the actuation of the lid-moving cylinder 108, the lid 102 moves between a processing position at which the lid 102 covers the top opening of the inner tank 100b and a retreat position beside the inner tank 100b. In the surface (upper surface) of the lid 102, there is provided a nozzle plate 112 having a large number of ejection nozzles 112a for ejecting, e.g., pure water outwardly (upwardly).

Further, as shown in FIG. 9, a nozzle plate 124 having a plurality of ejection nozzles 124a for ejecting upwardly a processing liquid supplied from a processing liquid tank 120 by driving a processing liquid pump 122 is provided in the inner tank 100b of the processing tank 100 in such a manner that the ejection nozzles 124a are equally distributed over the entire surface of the cross section of the inner tank 100b. A drainpipe 126 for draining a processing liquid (waste liquid) to the outside is connected to the bottom of the inner tank 100b. A three-way valve 128 is provided in the drainpipe 126 and the processing liquid (waste liquid) is returned to the processing liquid tank 120 through a return pipe 130 connected to one of outlet ports of the three-way valve 128 so as to reuse the processing liquid (waste liquid), as needed.

The first pre-processing apparatus 14a uses as a processing liquid a cleaning liquid comprising an inorganic acid such as HF, H₂SO₄, HCl, or the like, an organic acid such as oxalic acid, citric acid, or the like, or a mixture of such acids. In the first pre-processing apparatus 14a, the processing liquid (cleaning liquid) is ejected toward the surface of the substrate to remove an oxide film on the surfaces of the interconnects 8 for thereby activating the surfaces, and simultaneously to remove CMP residuals such as copper remaining on the surface of the insulating film 2 for thereby preventing a metal film from being formed on the surface of the insulating film 2. The amount of oxygen dissolved in the processing liquid should preferably be 3 ppm or smaller for preventing the surface of the substrate from being oxidized by oxygen included in the processing liquid and hence preventing the electrical properties of the activated interconnects frombeing adversely affected by oxidization.

The second pre-processing apparatus 14b uses as a processing liquid a catalyst imparting solution including at least a catalytic metal salt and a pH adjustment agent. The amount of oxygen dissolved in the catalyst imparting solution (processing liquid) should preferably be 3 ppm or smaller. The catalytic metal salt is contained in a range from 0.005 to 10 g/L, for example, in the catalyst imparting solution (processing liquid). The catalytic metal in the catalytic metal salt comprises at least one of Pd, Pt, Ru, Co, Ni, Au, and Ag, for example. It is preferable to use Pd as the catalytic metal for its reaction rate and better controllability.

The pH adjustment agent comprises an acid selected from hydrochloric acid, sulfuric acid, nitric acid, citric acid, oxalic acid, formic acid, acetic acid, maleic acid, malic acid, adipic acid, pimelic acid, glutaric acid, succinic acid, fumaric acid, and phthalic acid, or a base selected from an aqueous ammonia solution, KOH, tetramethylammonium hydride, and tetraethylammonium hydride. The pH of the catalyst imparting solution (processing liquid) is adjusted to a target value ±0.2 in the range from 0 to 6, for example, by the pH adjustment agent.

In this embodiment, the nozzle plate 112 mounted on the surface (upper surface) of the lid 102 is connected to a rinsing liquid supply source 132 which supplies a rinsing liquid such as pure water or the like. The rinsing liquid (pure water) with the amount of dissolved oxygen being 3 ppm or lower is ejected toward the surface of the substrate. A drain pipe127 is connected to the bottom of the outer tank 100a.

The processing head 60, which holds the substrate, is lowered until the processing head 60 covers the opening in the upper end of the inner tank 100b of the processing tank 100. Then, the processing liquid, i.e., the cleaning liquid in the first pre-processing apparatus 14a or the catalyst imparting solution in the second pre-processing apparatus 14b, is ejected from the ejection nozzles 124a of the nozzle plate 124 disposed in the inner tank 100b uniformly to the entire lower surface (surface to be processed) of the substrate W. The processing liquid, which has been ejected, is prevented from being scattered around and is discharged outside through the drainpipe 126.

The processing head 60 is then elevated. With the opening in the upper end of the inner tank 100b being closed by the lid 102, the rinsing liquid is ejected from the ejection nozzles 112a of the nozzle plate 112 on the upper surface of the lid 102 to the substrate W held by the processing head 60, thereby rinsing (cleaning) the processing liquid remaining on the surface of the substrate W. The rinsing liquid flows downwardly through the gap between the outer tank 100a and the inner tank 100b and is discharged through the drainpipe 127. The rinsing liquid is therefore prevented from flowing into the inner tank 100b and from being mixed with the processing liquid.

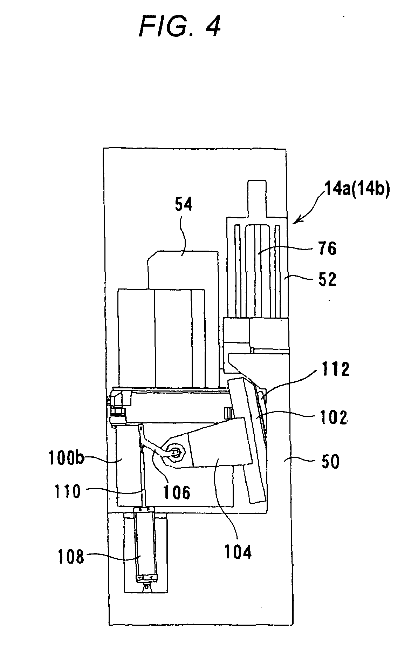

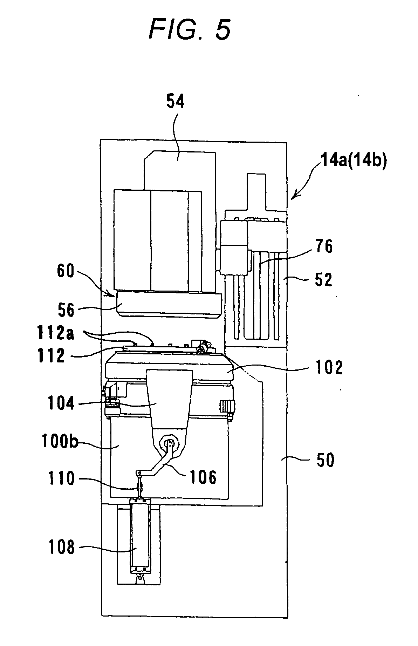

The pre-processing apparatuses 14a, 14b operate as follows: When the processing head 60 is elevated, as shown in FIG. 3, the substrate W is inserted into the processing head 60 and held thereby. Thereafter, as shown in FIG. 4, the processing head 60 is lowered until it is positioned to cover the opening in the upper end of the inner tank 100b of the processing tank 100. Then, while the processing head 60 is being rotated to rotate the substrate W held thereby, the cleaning liquid or the catalyst imparting solution is ejected from the ejection nozzles 124a of the nozzle plate 124 disposed in the inner tank 100b of the processing tank 100 uniformly to the entire lower surface of the substrate W. The processing head 60 is elevated to and stopped in a predetermined position, and, as shown in FIG. 5, the lid 102 is moved to a position in which it covers the opening in the upper end of the inner tank 100b of the processing tank 100. Then, the rinsing liquid is ejected from the ejection nozzles 112a of the nozzle plate 112 on the upper surface of the lid 102 to the substrate W held and rotated by the processing head 60. In this manner, the substrate W can be processed with the processing liquid and rinsed with the rinsing liquid such that the processing liquid and the rinsing liquid are not mixed with each other.

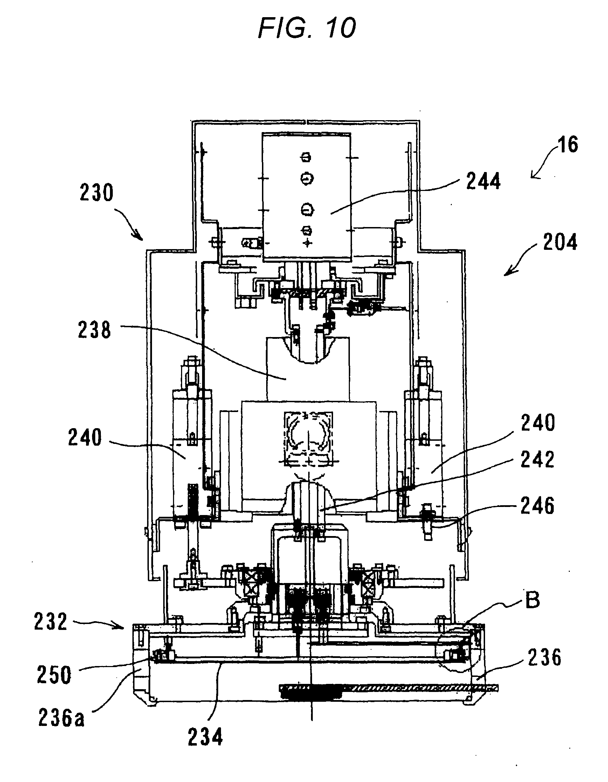

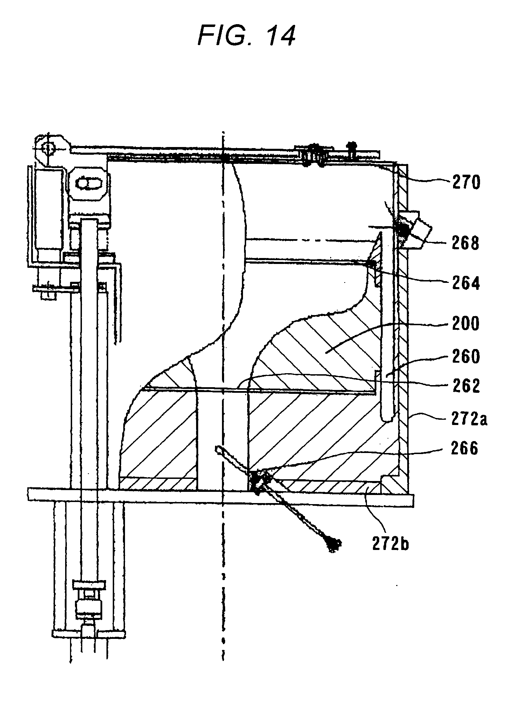

The electroless plating apparatus 16 is shown in FIGS. 10 through 16. The electroless plating apparatus 16 comprises a plating tank 200 (see FIG. 14) and a substrate head 204, disposed above the plating tank 200, for holding the substrate W detachably.

As shown in detail in FIG. 10, the substrate head 204 comprises a housing portion 230 and a head portion 232. The head portion 232 mainly comprises a suction head 234 and a substrate receiver 236 disposed around the suction head 234. The housing portion 230 accommodates therein a substrate rotating motor 238 and substrate receiver driving cylinders 240. The substrate rotating motor 238 has a hollow output shaft 242 having an upper end coupled to a rotary joint 244 and a lower end coupled to the suction head 234. The substrate receiver driving cylinders 240 have respective rods coupled to the substrate receiver 236. Stoppers 246 for mechanically limiting the substrate receiver 236 against upward movement are disposed in the housing portion 230.

A splined structure is provided between the suction head 234 and the substrate receiver 236. The substrate receiver 236 is vertically moved relative to the suction head 234 by the actuation of the substrate receiver driving cylinders 240. When the substrate rotating motor 238 is driven to rotate the output shaft 242, the suction head 234 and the substrate receiver 236 are rotated in unison with each other according to the rotation of the output shaft 242.

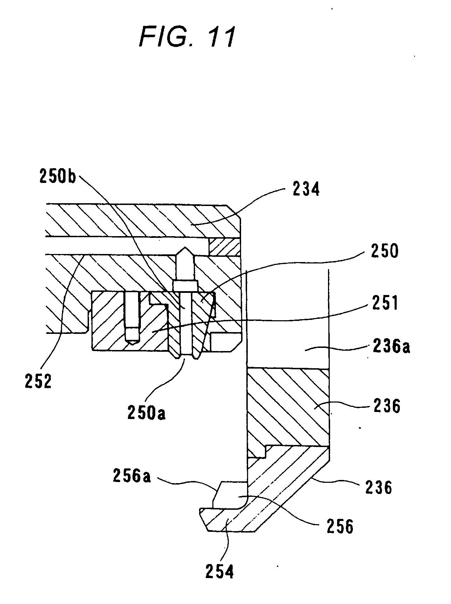

As shown in detail in FIGS. 11 through 13, a suction ring 250, for attracting and holding a substrate W against its lower surface to be sealed, is mounted on a lower circumferential edge of the suction head 234 by a presser ring 251. A recess 250a continuously defined in a lower surface of the suction ring 250 in a circumferential direction communicates with a vacuum line 252 extending inside of the suction head 234 via a communication hole 250b defined in the suction ring 250. By evacuating the recess 250a, the substrate W is attracted and held. Thus, the substrate W is attracted and held under vacuum along a (radially) narrow circumferential area. Accordingly, it is possible to minimize any adverse effects (flexing or the like) caused by the vacuum on the substrate W. Further, when the suction ring 250 is immersed in the plating solution (processing liquid), all portions of the substrate W including not only the front face (lower surface) of the substrate W, but also its circumferential edge can be immersed in the plating solution. The substrate W is released by supplying N₂ into the vacuum line 252.

Meanwhile, the substrate receiver 236 is in the form of a bottomed cylinder opened downward. Substrate insertion windows 236a for inserting the substrate W into the substrate receiver 236 are defined in a circumferential wall of the substrate receiver 236. A disk-like ledge 254 projecting inward is provided at a lower end of the substrate receiver 236. Protrusions 256 each having an inner tapered surface 256a for guiding the substrate W are provided on an upper portion of the ledge 254.

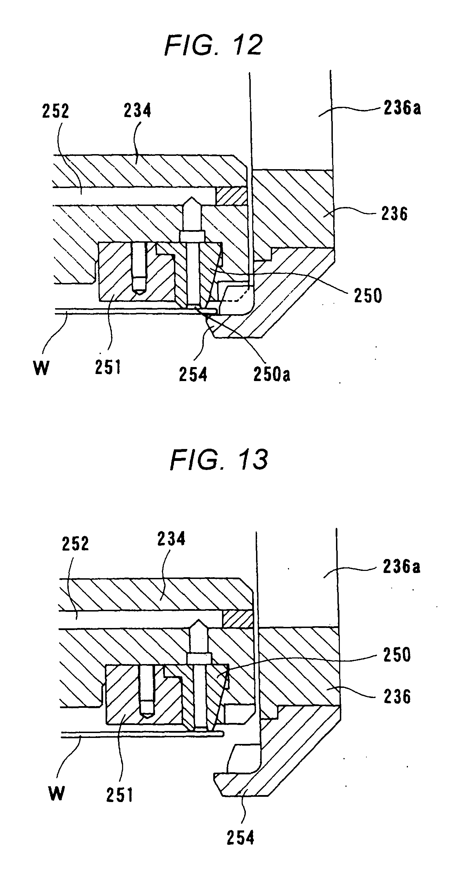

As shown in FIG. 11, when the substrate receiver 236 is in a lowered position, the substrate W is inserted through the substrate insertion window 236a into the substrate receiver 236. The substrate W is then guided by the tapered surfaces 256a of the protrusions 256 and positioned and placed at a predetermined position on an upper surface of the ledge 254 of the substrate receiver 236. In this state, as shown in FIG. 12, the substrate receiver 236 is lifted up so as to bring the upper surface of the substrate W placed on the ledge 254 of the substrate receiver 236 into abutment against the suction ring 250 of the suction head 234. Then, the recess 250a in the vacuum ring 250 is evacuated through the vacuum line 252 to attract and hold the substrate W while sealing the upper peripheral edge of the substrate W against the lower surface of the suction ring 250. For performing a plating process, as shown in FIG. 13, the substrate receiver 236 is lowered several millimeters to space the substrate W from the ledge 254 so that the substrate W is attracted and held only by the suction ring 250. Thus, it is possible to prevent the front face (lower surface) of the peripheral edge portion of the substrate W from not being plated because of the presence of the ledge 254.

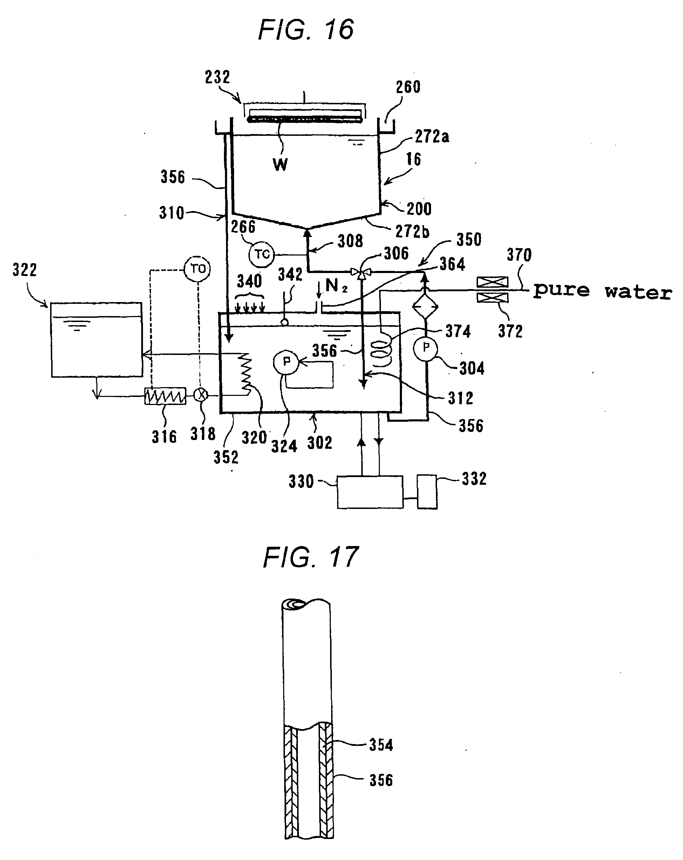

FIG. 14 shows the details of the plating tank 200. The plating tank 200 is connected at the bottom to a plating solution supply pipe 308 (see FIG. 16) and is provided in the peripheral wall with a plating solution recovery gutter 260. In the plating tank 200, there are disposed two current plates 262, 264 for stabilizing the flow of a plating solution flowing upward. A thermometer 266, for measuring the temperature of the plating solution to be introduced into the plating tank 200, is disposed at the bottom of the plating tank 200. Further, on the outer surface of the peripheral wall of the plating tank 200 and at a position slightly higher than the liquid level of the plating solution held in the plating tank 200, there is provided an ejection nozzle 268 for ejecting a stop liquid which is a neutral liquid having a pH of 6 to 7.5, for example, pure water, slightly upward with respect to a diametrical direction in the plating tank 200. After the plating, the substrate W held by the head portion 232 is lifted up and stopped at a position slightly above the liquid level of the plating solution. In this state, pure water (stop liquid) is ejected from the ejection nozzle 268 toward the substrate W to cool the substrate W immediately, thereby preventing progress of plating by the plating solution remaining on the substrate W.

A plating tank cover 270 is openably and closably placed in the opening in the upper end of the plating tank 200. While no plating process is being performed in the plating tank 200, e.g., while the electroless plating apparatus is idling, the plating tank cover 270 closes the opening in the upper end of the plating tank 200 to prevent the plating solution in the plating tank 200 from being evaporated and radiating its heat uselessly.

As shown in FIG. 16, the plating tank 200 is connected at the bottom to the plating solution supply pipe 308 extending from a plating solution reservoir tank 302 and having a plating solution supply pump 304 and a three-way valve 306. Further, the plating solution recovery gutter 260 is connected to a plating solution recovery pope 310 extending from the plating solution reservoir tank 302. Thus, during a plating process, a plating solution is supplied from the bottom of the plating tank 200 into the plating tank 200, and a plating solution, which has overflowed into the plating tank 200, is recovered to the plating solution reservoir tank 302 by the plating solution recovery gutter 260 through the plating solution recovery pope 310. Thus, the plating solution canbe circulated. A plating solution return pipe 312 for returning the plating solution to the plating solution reservoir tank 302 is connected to one of ports of the three-way valve 306. Accordingly, the plating solution can be circulated even at the time of a standby for plating. Thus, a plating solution circulating system 350 is constructed. The plating solution in the plating solution reservoir tank 302 is thus continuously circulated through the plating solution circulating system 350 to control particles in the plating solution by performing filtering.

Particularly, in this embodiment, by controlling the plating solution supply pump 304, the flow rate of the plating solution circulated at the time of a standby of plating or a plating process can be set individually. Specifically, the amount of the plating solution circulated at the time of the standby of plating is set to be in a range of 2 to 20 L/min, for example, and the amount of the plating solution circulated at the time of the plating process is set to be in a range of 0 to 10 L/min, for example. Thus, a large amount of the plating solution circulated at the time of the standby of plating can be ensured so as to maintain the temperature of a plating bath in a cell to be constant, and the amount of the plating solution circulated at the time of the plating process is reduced so as to deposit a protective film (plated film) having a more uniform thickness.

In this embodiment, a heat retention section, comprised of a heat insulatingmaterial, is provided in substantially the entire area of the plating solution circulation system 350. In particular, with respect to the plating tank 200, heat insulating materials (heat retention section) 272a, 272b are provided in the entire area expect the area which structurally allows contact between the plating solution and air upon plating, i.e., on the outer surfaces of the side wall and the bottom wall of the plating tank 200, as shown in FIG. 14. The entire outer surface of the plating solution reservoir tank 302 is also covered with a heat insulating material (heat retention section) 352. Further, a structure as shown in FIG. 17, comprisingapipe354andaheatinsulatingmaterial 356 covering the outer surface of the pipe 354, is employed in all the pipes of the plating solution circulation system 350, i.e., the plating solution supply pipe 308, the plating solution return pipe 312 and the plating solution recovery pipe 310.

By thus providing the heat retention system, comprised of a heat insulating material, in substantially the entire area of the plating solution circulation system 350 to minimize heat loss from the plating solution and thereby prevent lowering of the temperature of the plating solution in the entire plating solution circulation system 350, it becomes possible to allow the plating solution to circulate in the plating solution circulation system 350 while keeping the plating solution at a more constant temperature. This makes it possible to reduce a stress on the plating solution, which is produced upon a change in the temperature of the plating solution due to the presence of components having different temperature dependencies of pH, thereby extending the life of the plating solution, and to form a high-quality and uniform plated film at a low cost.

Though in this embodiment the heat retention section, comprised of a heat insulating material, is provided in substantially the entire area of the plating solution circulation system 350, it is also possible to provide the thermal insulating section (heat insulating material) only in substantially the entire area of the plating solution recoverypipe 310. Thus, the structure shown in FIG. 17, comprising the pipe 354 and the heat insulating material 356 covering the outer surface of the pipe 354, may be employed only for the plating solution recovery pipe 310. This effectively prevents lowering of the temperature of the plating solution due to heat loss from the plating solution as it flows in the plating solution recovery pipe 310 from the plating tank 200 to the plating solution reservoir tank 302. Thus, the plating solution can be kept at a higher temperature when it flows into the plating solution in the plating solution reservoir tank 302.

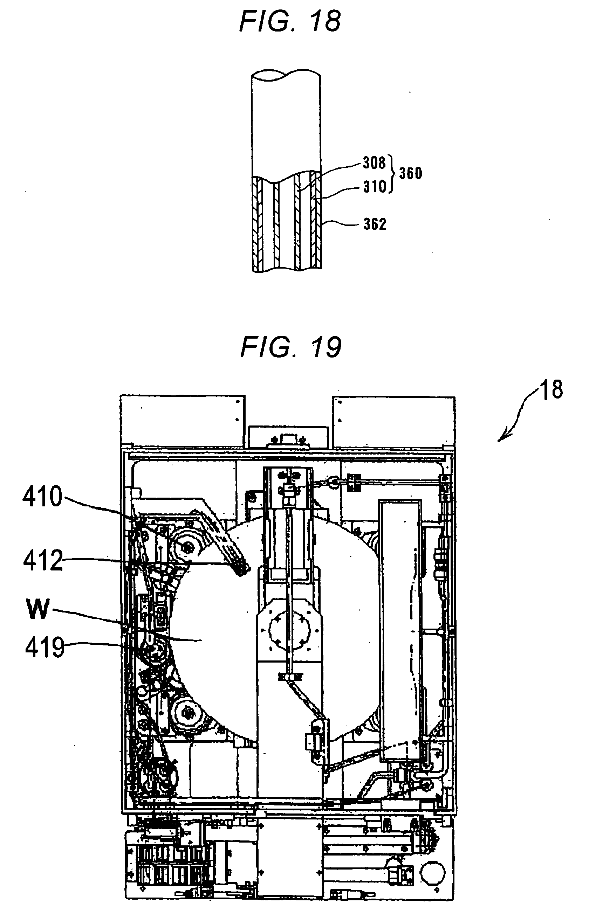

It is also possible to employ, as a heat retention section for the plating solution supply pipe 308 and the plating solution recovery pipe 310, a double pipe 360 as shown in FIG. 18, composed of the plating solution supply pipe 308 as an inner pipe and the plating solution recovery pipe 310 as an outer pipe concentrically covering the inner pipe. The outer circumferential surface of the double pipe 360 may be covered with a heat insulating material 362, according to necessity. According to this embodiment, heat loss from the plating solution flowing along the plating solution supplypipe 308 can be prevented by configuring the plating solution supply pipe (inner pipe) 308 to be kept from direct contact with the outside air. Furthermore, the plating solution flowing along the plating solution recovery pipe (outer pipe) 310 can be heated with the high-temperature plating solution flowing along the plating solution supply pipe 308. The heat capacity of the high-temperature plating solution can thus be utilized effectively.

Though not shown diagrammatically, it is also possible to use a ribbon heater as a heat retention section, or to employ a so-called jacket structure in which the entire plating solution circulation system is covered with a liquid heated to a predetermined temperature. Such a jacket structure, because of the large heat capacity of the liquid, can prevent a plating solution from being cooled rapidly when electricity becomes unavailable, for example, due to an apparatus failure.

The thermometer 266 provided in the vicinity of the bottom of the plating tank 200 measures the temperature of the plating solution to be introduced into the plating tank 200 and controls a heater 316 and a flow meter 318 described below based on the measurement results.

Specifically, in this embodiment, there are provided a heating device 322 for heating the plating solution indirectly by a heat exchanger 320 provided in the plating solution in the plating solution reservoir tank 302 and employing, as a heating medium, water that has been increased in temperature by a separate heater 316 and passed through the flow meter 318, and a stirring pump 324 for circulating the plating solution in the plating solution reservoir tank 302 to stir the plating solution. This is because the apparatus should be arranged so that the apparatus can cope with a case where the plating solution is used at a high temperature (about 80°C). This method can prevent an extremely delicate plating solution from being mixed with foreign matter or the like, unlike an in-line heating method.

According to this embodiment, the plating solution is set such that a temperature of the substrate is 70 to 90°C duringplating by bringing it into contact with the substrate W, and is controlled such that the range of variations in liquid temperature is within ±2°C.

To the top of the plating solution reservoir tank 302 is connected an inert gas introduction pipe 364 for introducing an inert gas, such as N₂, into the plating solution reservoir tank 302 to replace the internal atmosphere of the plating solution reservoir tank 302 with an inert gas atmosphere. By thus replacing the internal atmosphere of the plating solution reservoir tank 302 with an inert gas atmosphere, carbon dioxide in the air can be prevented from dissolving in the high-pH plating solution to cause a change in the pH of the plating solution. The temperature of the inert gas is not more than room temperature unless it is heated. Deaeration of the plating solution by inert gas bubbling increases the surface area of the plating solution in contact with the air whose temperature is lower than that of the plating solution. It is therefore preferred that the inert gas be preheated so that the temperature of the plating solution in the plating solution reservoir tank 302 will not be lowered by the introduction of the inert gas.

According to this electroless plating apparatus 16, when the substrate head 204 is in a lifted position, the substrate W is attracted to and held in the head portion 232 of the substrate head 204 as described above, while the plating solution in the plating tank 200 is circulated.

When a plating process is performed, the plating tank cover 270 of the plating tank 200 is opened, and the substrate head 204 is lowered while being rotated. Thus, the substrate W held in the head portion 232 is immersed in the plating solution in the plating tank 200.

After immersing the substrate W in the plating solution for a predetermined period of time, the substrate head 204 is raised to lift the substrate W from the plating solution in the plating tank 200 and, as needed, pure water (stop liquid) is ejected from the ejection nozzles 268 toward the substrate W to immediately cool the substrate W, as described above. The substrate head 204 is further raised to lift the substrate W to a position above the plating tank 200, and the rotation of the substrate head 204 is stopped.

Next, the top opening portion of the plating tank 200 is covered with the plating tank cover 270, and the cleaning liquid (rinsing liquid) such as pure water is sprayed from the spray nozzles 280 to clean (rinse) the substrate W, while rotating the substrate head.

After completion of cleaning of the substrate W, the rotation of the substrate head 204 is stopped, and the substrate head 204 is raised to lift the substrate W to a position above the cleaning tank 202. Further, the substrate head 204 is moved to a transfer position between the transport robot 26 and the substrate head 204. Then, the substrate W is delivered to the transport robot 26 and is transferred to a subsequent process.

The plating solution reservoir tank 302 is provided with a liquid level sensor 342 for measuring the liquid level of the plating solution in the plating solution reservoir tank 302 to thereby measure a decrease in the amount of the plating solution due to evaporation of moisture, and a pure water replenishment pipe 370 for supplying pure water (ultrapure water) to the plating solution in the plating solution reservoir tank 302 based on a signal from the liquid level sensor 342, thereby replenishing the plating solution with a shortage of moisture. In the pure water replenishment pipe 370 is provided a preheating section 372 for preheating pure water, flowing along the pure water replenishment pipe 370, to the temperature of the plating solution. Further, the front end of the pure water replenishment pipe 370 is connected to a spiral heat exchange pipe 374 disposed in the plating solution in the plating solution reservoir tank 302.

Since a large amount of moisture evaporates from a high-temperature plating solution, the plating solution needs to be frequently replenished with pure water. By replenishing the plating solution in the plating solution reservoir tank 302 with pure water which has been preheated to the temperature of the plating solution, according to this embodiment, lowering of the temperature of the plating solution in the plating solution reservoir tank 302 upon the supply of pure water can be prevented. Furthermore, since the front end of the pure water replenishment pipe 370 is connected to the heat exchange pipe 374 disposed in the plating solution in the plating solution reservoir tank 302, even when the replenishing pure water falls in temperature, the pure water can be brought closer to the temperature of the plating solution in the plating solution reservoir tank 302 upon its supply to the plating solution.

Though in this embodiment pure water flowing along the pure water replenishment pipe 370 is preheated by the preheating section 372 before supplying the pure water to the plating solution in the plating solution reservoir tank 302, it is also possible to preheat pure water to the same temperature as the temperature of the plating solution before supplying the pure water to a pure water replenishment pipe, and supply the preheated pure water through the pure water replenishment pipe to the plating solution in the plating solution reservoir tank.

As shown in FIG. 16, the electroless plating apparatus 16 is also provided with a plating solution composition analyzing section 330 for analyzing the composition of the plating solution held by the electroless plating apparatus 16 by, for example, absorption spectroscopy, titration, or an electrochemical measurement.

The plating solution component analyzing section 330 measures, for example, the concentration of cobalt ion by absorbance analysis of a plating solution, ion chromatography analysis, capillary electrophoresis analysis or chelatometry analysis; the concentration, in terms of tungsten, of tungstate by capillary electrophoresis analysis; the concentration of hypophosphite ion and/or dimethylamine borane by redox titration analysis or capillary electrophoresis analysis; and the concentration of a chelating agent by chelatometry analysis or capillary electrophoresis analysis. The concentration in terms of tungsten may also be calculated and determined from the consumption of Co ion or Ni ion.

The pH of the plating solution is measured by an electrode method. The pH of the plating solution is set at 7 to 9.8 as measured at 25°C. Accordingly, the pH of the plating solution in operation is preferably measured after cooling a sampled plating solution to a predetermined temperature. However, the pH of a sampled plating solution at a high temperature is preferably measured at the high temperature without cooling the sample when the plating solution has been used for a length of time and there is a fear that a deviation of the pH of the plating solution at a high temperature from the pH of the plating solution at a predetermined temperature is no more constant because of the presence of a by-product or a chemical added for component replenishment.

The plating apparatus also includes a component replenishment section 340 for replenishing the plating solution with a shortage of a component based on the results of the above analyses. The following replenisher solutions may be supplied from the component replenishment section 340 to the plating solution: a solution containing a cobalt ion to replenish the plating solution with a shortage of cobalt ion; a solution containing tungstic acid to replenish the plating solution with a shortage of tungstic acid; a solution containing a hypophosphite ion and/or dimethylamine borane to replenish the plating solution with a shortage of hypophosphite ion and/or dimethylamine borane; a solution containing a chelating agent to replenish the plating solution with a shortage of chelating agent; and a solution containing a pH adjustment agent to correct a change in the pH of the plating solution.

Also when thus replenishing the plating solution with a consumed component according to necessity, a replenish solution containing that component is preferably preheated to the temperature of the plating solution so that the temperature of the plating solution will not be lowered.

The pH of the plating solution is preferably controlled within the range of ±0.2, more preferably ±0.005, with respect to a set value. The range of variation of the concentration of cobalt ion is preferably ±2.0%, more preferably ±1.0%. The range of variation of the concentration of tungstic acid, in terms of tungsten, is preferably ±4.0%, more preferably ±2.0%. The range of variation of the concentration of hypophosphite ion and/or dimethylamine borane is preferably ±4.0%, more preferably ±2.0%. The range of variation of the concentration of chelating agent is preferably ±3.0%, more preferably ±1.5%.

The plating solution reservoir tank 302 is provided with a film-formation measurement section which includes a crystal oscillator to be immersed in the plating solution, and measures the rate of the formation of a protective film 9 by utilizing attenuation of the oscillation frequency of the crystal oscillator with deposition of an electroless plated film on the crystal oscillator. The film-formation rate of the protective film 9 during its formation can thus be measured by the measurement section.

By thus measuring the film-formation rate of the protective film 9 during its formation, it becomes possible to check whether the film-formation rate meets a predetermined rate. Further, by controlling the plating time based on the results of measurement of the film-formation rate of the protective film, in particular, by increasing or decreasing the plating time according to necessity when excess or deficiency in the film-formation rate is revealed, an alloy film having a predetermined thickness can be formed with good reproducibility.

When a plating solution is used repeatedly, a particular component can accumulate in the plating solution by supply from the outside or self-decomposition of the plating solution, which could adversely affect the reproducibility of plating and the quality of a plated film. Provision of a mechanism for selective removal of such a component can extend the life of the plating solution and enhance the reproducibility of plating.

A description will now be made of a plating solution for use in the electroless plating apparatus 16. Maximum extension of the life of a plating solution becomes possible by using as the electroless plating apparatus 16 one configured to make the plating solution hardly become unstable upon a change in the temperature of the plating solution, and by using as the plating solution one which is hardly affected by a change in its temperature. The following is an example of a basic composition of a plating solution for use in the formation of a plated film (protective film) of a CoWP alloy by electroless plating:
Basic composition of plating solution
   · CoSO₄ · 7H₂O 7 g/L
   · Na₃C₆H₅O₇ · 2H₂O 44 g/L
   · H₃BO₃ 15 g/L
   · Na₂WO₄·2H₂O 6 g/L
   · Na₂H₂PO₂·H₂O 10 g/L

Citric acid as a complexing agent is used in the plating solution so that a metal ion will not precipitate as a hydroxide even the pH of the plating solution is high. The plating solution also contains boric acid as a buffer in order to prevent a change in pH at a reaction surface due to a reaction of phosphinic acid as a reducing agent and to grow a uniform plated film. The buffer has a sufficient buffer capacity when the pH of the plating solution is adjusted to a predetermined value. The complexing agent is an essential component, and is used in a concentration of at least equal to the concentration of metal ion.

When a plating solution contains citric acid, which is used as a complexing agent for complexing a cobalt ion, the pH of the plating solution increases as the temperature rises. On the other hand, when a plating solution contains boric acid, which is used as a buffer for a plating solution having a pH of about 9, the pH of the plating solution decreases as the temperature rises. Because of the co-presence of the two components, whose temperature dependencies of pH are contradictory, in the above plating solution, the pH of the plating solution can change with a change in the temperature of the plating solution, which could make the plating solution unstable. In view of this, according to this embodiment, the components of plating solution are adjusted in the following manner so as to best prevent destabilization of the plating solution upon a change in the temperature of the plating solution.

The concentration of boric acid, which is used as a buffer for stabilizing the pH of a plating solution at a value around 9, is adjusted to 5 to 20 g/L in terms of orthoboric acid (H₃BO₃). In view of the solubility of borax of 2.67 g/100 g at 10°C, pH 9.8, there is a fear of precipitation of borate crystals in the plating solution when the concentration of boric acid is higher than 15 g/L, whereas the buffer capacity of boric acid can be insufficient when the concentration is lower than 5 g/L. The concentration of boric acid is preferably 10 to 15 g/L.

The concentration of citric acid is basically at least twice the concentration of boric acid and at least 5 times the concentration of cobalt ion, and is specifically preferably 0.1 to 0.5 mol/L.

As will be appreciated from the above, such concentration of boric acid that may provide a minimum of buffer capacity will suffice, while the concentration of citric acid is desirably higher than the concentration of boric acid and such as to sufficiently complex a cobalt ion. A high concentration of citric acid is preferred because citric acid contributes more to destabilization of the plating solution upon a temperature change. On the other hand, however, an alkali metal, such as sodium or potassium, in an amount responding to the concentration of citric acid and the concentration of boric acid is needed in order to increase or adjust the pH of the plating solution. When the concentration of an alkali metal, especially sodium, is high, borax crystals are likely to precipitate due to the solubility product of sodium ion and borate ion. In addition, the presence of a high concentration of alkali metal in the high-temperature, high-pHplating solution could cause dissolution of an oxide film. In view of the above, the concentration of citric acid preferably is not more than 0.5 mol/L, though the acid may be present in excess merely from the viewpoint of plating reaction.

Since an alkali metal-free plating solution is desired, it may be considered to use an ammonia alkali. However, an ammonia alkali causes a large pH change, even larger as compared to boric acid, upon a change in the temperature of a plating solution. It is thus possible that the use of an ammonia alkali may make the plating solution more likely to become unstable. Therefore, more attention must be paid to the temperature control of an ammonia alkali-containing plating solution, compared to an alkali metal-containing plating solution. In case the use of a certain amount of alkali metal is possible, it is preferred to use both of an ammonia alkali and an alkali metal for pH adjustment of the plating solution rather than solely using an ammonia alkali.

In electroless plating, the plating rate is higher at a higher temperature of plating solution, and a plating reaction does not occur at a too low temperature. In view of this, the temperature of the present plating solution is generally 60 to 95°C, preferably 65 to 85°C, more preferably 70 to 75°C. It is basically desirable not to lower the temperature of the plating solution after once raising the temperature, regardless of whether plating is actually being carried out or not, and to keep the plating solution at a temperature of not less than 55°C.

The pH of the plating solution is preferably adjusted to 7 to 9.8 as measured at 25°C.

The concentration of phosphoric acid, which not only affects the rate of plating reaction as a reducing agent, but is determinative of the P concentration of the plated film (protective film) of CoWP alloy, preferably is 0.1 to 0.5 mol/L. The concentration of tungstic acid, which is not only determinative of the W concentration of the plated film (protective film) of CoWP alloy, but affects the rate of plating reaction as well, is not more than 0.05 mol/L and, in terms of tungsten, 0.004 to 0.1 mol/L, preferably 0.004 to 0.05 mol/L.

The concentration of cobalt ion is generally 0.01 to 0.13 mol/L, preferably 0.01 to 0.1 mol/L, more preferably 0.01 to 0.03 mol/L. In this regard, the use of a higher cobalt ion concentration necessitates a higher citric acid concentration. This requires the use of a higher concentration of an alkali or an equivalent ion for adjustment of the pH of the plating solution, which could cause unexpected precipitation of crystals.

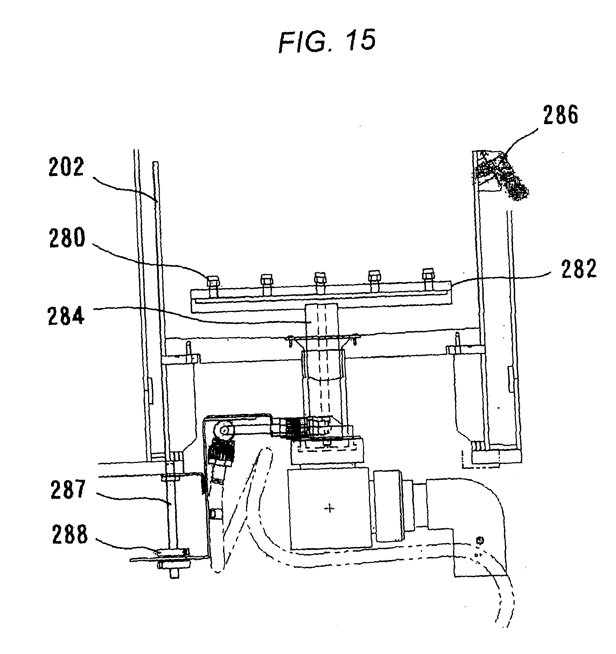

FIG. 15 shows the details of a cleaning tank 202 provided beside the plating tank 200. At the bottom of the cleaning tank 202, there is provided a nozzle plate 282 onto which a plurality of ejection nozzles 280 for ejecting a rinsing liquid such as pure water upward are attached. The nozzle plate 282 is coupled to an upper end of a nozzle vertical shaft 284. The nozzle vertical shaft 284 can be moved vertically by changing positions of engagement between a nozzle position adjustment screw 287 and a nut 288 engaging the screw 287 so as to optimize a distance between the ejection nozzles 280 and the substrate W disposed above the ejection nozzles 280.

Further, on the outer surface of the peripheral wall of the cleaning tank 202 and at a position higher than the ejection nozzles 280, there is provided a head cleaning nozzle 286 for ejecting a cleaning liquid such as pure water slightly downward with respect to a diametric direction in the cleaning tank 202 to blow the cleaning liquid to at least a portion of the head portion 232 of the substrate head 204 which is brought into contact with the plating solution.

In the cleaning tank 202, the substrate W held in the head portion 232 of the substrate head 204 is located at a predetermined position in the cleaning tank 202. A cleaning liquid (rinsing liquid) such as pure water is ejected from the ejection nozzles 280 to clean (rinse) the substrate W. At that time, a cleaning liquid such as pure water is ejected from the head cleaning nozzle 286 to clean, with the cleaning liquid, at least a portion of the head portion 232 of the substrate head 204 which is brought into contact with the plating solution, thereby preventing a deposit from accumulating on a portion which is immersed in the plating solution.

According to this electroless plating apparatus 16, when the substrate head 204 is in a lifted position, the substrate W is attracted to and held in the head portion 232 of the substrate head 204 as described above, while the plating solution in the plating tank 200 is circulated.

When a plating process is performed, the plating tank cover 270 of the plating tank 200 is opened, and the substrate head 204 is lowered while being rotated. Thus, the substrate W held in the head portion 232 is immersed in the plating solution in the plating tank 200.

After immersing the substrate W in the electroless plating solution for a predetermined period of time, the substrate head 204 is raised to lift the substrate W from the electroless plating solution in the plating tank 200 and, as needed, pure water (stop liquid) is ejected from the ejection nozzles 268 toward the substrate W to immediately cool the substrate W, as described above. The substrate head 204 is further raised to lift the substrate W to a position above the plating tank 200, and the rotation of the substrate head 204 is stopped.

Next, while the substrate W is attracted to and held in the head portion 232 of the substrate head 204, the substrate head 204 is moved to a position right above the cleaning tank 202. While the substrate head 204 is rotated, the substrate head 204 is lowered to a predetermined position in the cleaning tank 202. A cleaning liquid (rinsing liquid) such as pure water is ejected from the ejection nozzles 280 to clean (rinse) the substrate W. At that time, a cleaning liquid such as pure water is ejected from the head cleaning nozzle 286 to clean at least a portion of the head portion 232 of the substrate head 204 which is brought into contact with the plating solution.

After completion of cleaning of the substrate W, the rotation of the substrate head 204 is stopped, and the substrate head 204 is raised to lift the substrate W to a position above the cleaning tank 202. Further, the substrate head 204 is moved to a transfer position between the second substrate transport robot 26 and the substrate head 204. Then, the substrate W is delivered to the second substrate transport robot 26 and is transferred to a subsequent process.

FIG. 19 shows the post-processing apparatus 18. The post-processing apparatus 18 is an apparatus for forcibly removing particles and unnecessary matters on the substrate W with a roll-shaped brush, and includes a plurality of rollers 410 for holding the substrate W by nipping its peripheral portion, a chemical nozzle 412 for supplying a chemical liquid (two lines) to the front surface of the substrate W held by the rollers 410, and a pure water nozzle (not shown) for supplying pure water (one line) to the back surface of the substrate W.

In operation, the substrate W is held by the rollers 410 and a roller drive motor is driven to rotate the rollers 410 and thereby rotate the substrate W, while predetermined chemical liquids are supplied from the chemical nozzle 412 and the pure water nozzle to the front and back surfaces of the substrate W, and the substrate W is nipped between not-shown upper and lower roll sponges (roll-shaped brushes)at an appropriate pressure,thereby cleaning the substrate W. It is also possible to rotate the roll sponges independently so as to increase the cleaning effect.

The post-processing apparatus 18 also includes a sponge (PFR) 419 that rotates while contacting the edge (peripheral portion) of the substrate W, thereby scrub-cleaning the edge of the substrate W.

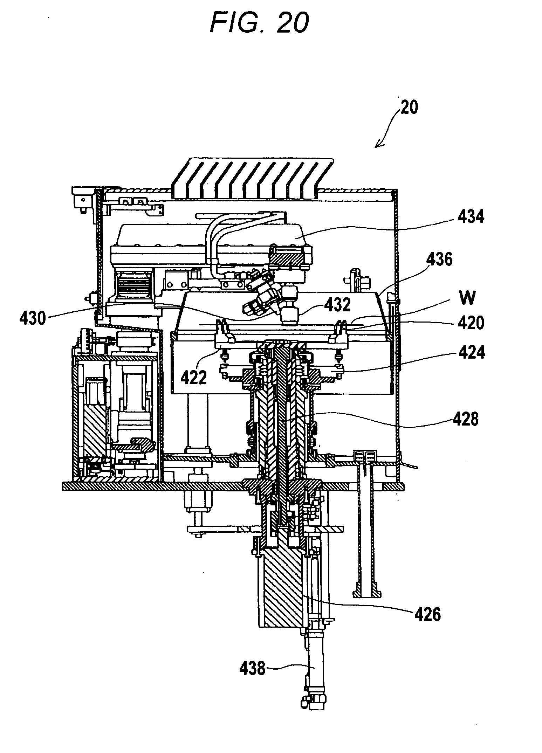

FIG. 20 shows the drying apparatus 20. The drying apparatus 20 is an apparatus for first carrying out chemical cleaning and pure water cleaning of the substrate W, and then fully drying the cleaned substrate W by spindle rotation, and includes a substrate stage 422 provided with a clamping mechanism 420 for clamping an edge portion of the substrate W, and a substrate attachment/detachment lifting plate 424 for opening/closing the clamping mechanism 420. The substrate stage 422 is coupled to the upper end of a spindle 428 that rotates at a high speed by the actuation of a spindle rotating motor 426.

Further, positioned on the side of the upper surface of the substrate W clamped by the clamping mechanism 420, there are provided a mega-jet nozzle 430 for supplying pure water to which ultrasonic waves from a ultrasonic oscillator have been transmitted during its passage through a special nozzle to increase the cleaning effect, and a rotatable pencil-type cleaning sponge 432, both mounted to the free end of a pivot arm 434. In operation, the substrate W is clamped by the clamping mechanism 420 and rotated, and the pivot arm 434 is pivoted while pure water is supplied from the mega-jet nozzle 430 to the cleaning sponge 432 and the cleaning sponge 432 is rubbed against the front surface of the substrate W, thereby cleaning the front surface of the substrate W. A cleaning nozzle (not shown) for supplying pure water is provided also on the side of the back surface of the substrate W, so that the back surface of the substrate W can also be cleaned with pure water sprayed from the cleaning nozzle at the same time.

The thus-cleaned substrate W is spin-dried by rotating the spindle 428 at a high speed.

A cleaning cup 436, surrounding the substrate W clamped by the clamping mechanism 420, is provided for preventing scattering of a cleaning liquid. The cleaning cup 436 is designed to move up and down by the actuation of a cleaning cup lifting cylinder 438.

It is also possible to provide the drying apparatus 20 with a cavi-jet function utilizing cavitation.

Next, a description will now be given of a series of substrate processings (electroless plating processings) as carried out by this substrate processing apparatus. In this example, as shown in FIG. 1, a protective film (cap material) 9 of a CoWP alloy is selectively formed to protect the interconnects 8.

First, one substrate W is taken by the first substrate transport robot 24 out of the cassette set in the loading/unloading unit 10 and housing substrates W with their front surfaces facing upwardly (face up), each substrate W having been subjected to the formation of interconnects 8 in the surface, and the substrate W is transported to the temporary storage table 22 and placed on it. The substrate W on the temporary storage table 22 is transported by the second substrate transport robot 26 to the first pre-processing apparatus 14a.

In the first pre-processing apparatus 14a, the substrate W is held face down, and a pre-cleaning with a cleaning liquid (processing liquid) is performed onto a surface of the substrate W. Specifically, the substrate W is held by substrate holder 58, and then the processing head 60 is positioned to cover the opening in the upper end of the inner tank 100b, as shown in FIG. 4. Then, the processing liquid (cleaning liquid) in the processing liquid tank 120 is ejected form the ejection nozzles 112a of the nozzle plate 120 disposed in the inner tank 100b to the substrate W, thereby etching away an oxide filmor the like on interconnects 8 to activate the surfaces of interconnects 8. At the same time, CMP residues of, e.g., copper remaining on a surface of an insulating film 2 is removed. The processing head 60 is elevated to a predetermined position, and the lid 102 is moved to cover the opening in the upper end of the inner tank 100b. Then, the rinsing liquid such as pure water is ejected from the ejection nozzles 112a of the nozzle plate 112 on the upper surface of the lid 102 to the substrate W to clean (rinse) the substrate W. The substrate W is then transferred to the second pre-processing apparatus 14b by the second substrate transfer robot 26.

In the second pre-processing apparatus 14b, the substrate W is held face down, and a catalyst impartation process is performed onto the surface of the substrate W. Specifically, the substrate W is held by substrate holder 58, and then the processing head 60 is positioned to cover the opening in the upper end of the inner tank 100b, as shown in FIG. 4. Then, the processing liquid (catalyst imparting solution) in the processing liquid tank 120 is ejected form the ejection nozzles 112a of the nozzle plate 112 disposed in the inner tank 100b to the substrate W so as to adhere Pd as a catalyst to the surfaces of the interconnects 8. More specifically, Pd cores are formed as catalyst cores (seeds) on the surfaces of the interconnects 8 to activate exposed surfaces of the interconnects 8. The processing head 60 is then elevated to a predetermined position, and the lid 102 is moved to cover the opening in the upper end of the inner tank 100b. Then, the rinsing liquid such as pure water is ejected from the ejection nozzles 112a of the nozzle plate 112 on the upper surface of the lid 102 to the substrate W to clean (rinse) the substrate W. The substrate W is then transferred to the electroless plating apparatus 16 by the second substrate transfer robot 26.

In the electroless plating apparatus 16, the substrate head 204 holding the substrate W in a face-down manner is lowered to immerse the substrate W in the plating solution in the plating tank 200, thereby carrying out electroless plating (electroless CoWP cap plating). For example, the substrate W is immersed in a CoWP plating solution at a liquid temperature of 80°C, e.g. for about 120 seconds to carry out selective electroless plating (electroless CoWP cap plating) on the activated surfaces of interconnects 8.

After the substrate W is pulled up from the liquid surface of the plating solution, a stop liquid such as pure water is ejected from the ejection nozzle 268 toward the substrate W to replace the plating solution on the surface of the substrate W with the stop liquid and stop the electroless plating. Next, the substrate head 204 holding the substrate W is located at a predetermined position in the cleaning tank 202. Pure water is ejected from the ejection nozzles 280 of the nozzle plate 282 disposed in the cleaning tank 202 to clean (rinse) the substrate W. At the same time, pure water is ejected from the head cleaning nozzle 286 to the head portion 232 to clean the head portion 232. The protective film 9 of CoWP alloy is thus formed selectively on the surfaces of interconnects 8 to protect interconnects 8.

Next, the substrate W after the electroless plating is transported by the second substrate transport robot 26 to the post-processing apparatus 18, where the substrate W is subjected to post-plating processing (post-cleaning) in order to enhance the selectivity of the protective film (alloy film) 9 formed on the surface of the substrate W and thereby increase the yield. In particular, while applying a physical force to the surface of the substrate W, for example, by roll scrub cleaning or pencil cleaning, a post-plating processing liquid (chemical solution) is supplied onto the surface of the substrate W to thereby completely remove plating residues, such as fine metal particles, from the insulating film (interlevel dielectric layer) 2, thus enhancing the selectivity of plating.

The substrate W after the post-plating process is transported by the second substrate transport robot 26 to the drying apparatus 20, where the substrate W is rinsed, according to necessity, and then rotated at a high speed to spin-dry the substrate W.

The spin-dried substrate W is placed by the second substrate transport robot 26 on the temporary storage table 22, and the substrate W placed on the temporary storage table 22 is returned by the first substrate transport robot 24 to the substrate cassette set in the loading/unloading unit 10.

In the above embodiments, the interconnect material is copper (Cu), and the protective film 9 in the form of a CoWP alloy film is selectively formed on the surfaces of interconnects 8 of copper. However, the interconnect material may be a Cu alloy, Ag, or an Ag alloy, and the protective film 9 may be a film of CoWB, CoP, CoB, a Co alloy, NiWP, NiWB, NiP, NiB, or a Ni alloy.

In the above embodiments, the surfaces of interconnects 8 are activated, and the protective film (metal film) 9 is selectively formed on the surfaces of interconnects 8. However, the surface of the substrate with the interconnect recesses 4 shown in FIG. 1 may be activated, and the metal filmmay be formed on the activated surfaces.

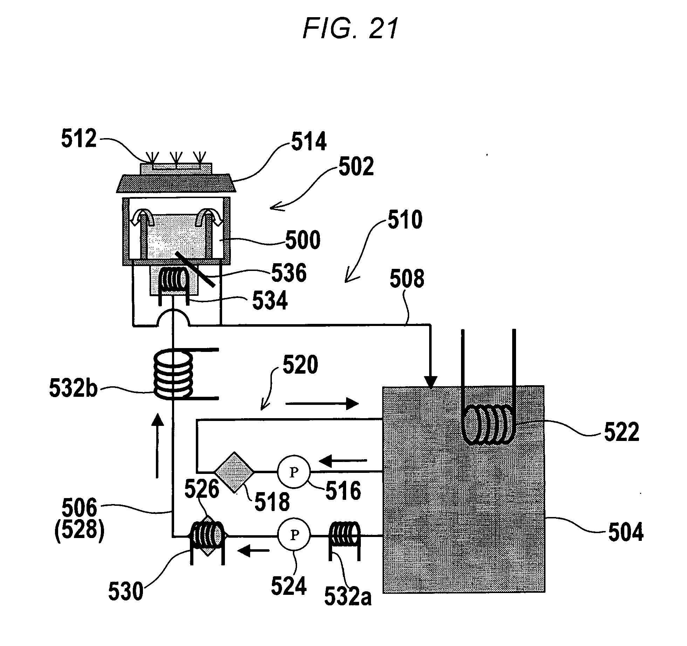

FIG. 21 shows an electroless plating apparatus according to another embodiment of the present invention. This electroless plating apparatus is best suited for use in carrying out plating while circulating a plating solution at a low flow rate (e.g., not more than 3 L/min).

The electroless plating apparatus includes a plating tank 502 with an overflow tank 500 provided around it, a plating solution reservoir tank 504 for storing therein a plating solution, a plating solution supply passage 506 for supplying the plating solution in the plating solution reservoir tank 504 to the plating tank 502, and a plating solution recovery passage for returning the plating solution, which has overflowed into the overflow tank 500, to the plating solution reservoir tank 504. A plating solution circulation system 510, which supplies the plating solution in the plating solution reservoir tank 504 to the plating tank 502 in a circulatory manner, is thus constructed.

The plating tank 502 is provided with a lid 514 which can cover the top-end opening of the plating tank 502 so that it is closed, and has ejection nozzles 512 for ejecting a rinsing liquid, such as pure water, toward a substrate when the top-end opening of the plating tank 502 is covered with the lid 514.

The plating solution reservoir tank 504 is provided with a plating solution stirring passage 520, having a circulation pump 516 and a filter 518 interposed, for circulating and stirring the plating solution in the plating solution reservoir tank 504, and a plating solution reservoir tank heater 522 for heating the plating solution in the plating solution reservoir tank 504. The plating solution in the plating solution reservoir tank 504 can thus be heated uniformly while circulating and stirring the plating solution by the plating solution stirring passage 520.

The plating solution supply passage 506 is comprised of a plating solution supply pipe 528 having a plating solution supply pump 524 and a filter 526 interposed. A filter heater 530 is disposed around the filter 526, and pipe heaters 532a, 532b are disposed around the plating solution supply pipe 528. The plating solution flowing along the plating solution supply passage 506 is heated by the heaters 530, 532a, 532b, whereby heat loss from the plating solution during its feeding from the plating solution reservoir tank 504 to the plating solution tank 502 can be minimized.

At the bottom of the plating tank 502 is disposed a plating tank heater 534 for heating the plating solution in the plating tank 502. The plating tank 502 is also provided with a thermometer 536 for measuring the temperature of the plating solution in the plating tank 502 and controlling the plating tank heater 534. Thus, the plating tank heater 534 is feedback-controlled by an output from the thermometer 536.

According to this embodiment, plating is carried out by bringing a surface of a substrate into contact with the plating solution in the plating tank 502 while uniformly heating the plating solution in the plating solution reservoir tank 504 to keep the plating solution at a predetermined temperature, and supplying the plating solution at the predetermined temperature in the plating solution reservoir tank 504 into the plating tank 502 in a circulatory manner.

Heat loss from the high-temperature plating solution, flowing from the plating solution reservoir tank 504 to the plating tank 502 along the plating solution supplypassage 506, can be minimized by the heaters 530, 532a, 532b disposed in the plating solution supply passage 506. Lowering of the temperature of the plating solution during its feeding through the plating solution supply passage 506 can thus be minimized with minimum influence on the plating solution. Further, by using, as the plating heater 534 disposed at the bottom of the plating tank 502, a heater having aminimumvolume, the apparatus cost canbe reduced and the apparatus can be downsized.

It becomes possible with this embodiment to keep the temperature of the plating solution in the plating tank 502 within the range of ±1°C of a predetermined temperature even when the flow rate of the circulating plating solution is low (not more than 3 L/min).

While the present invention has been described with reference to the embodiments thereof, it is understood that the present invention is not limited to the particular embodiments, but various modifications may be made therein within the technical concept of the invention.

### Industrial Applicability

The present invention is suitably used for an electroless plating apparatus used for forming, on bottom surfaces and side surfaces or exposed surfaces of embedded interconnects which have been formed by embedding an interconnect material (conductive material), such as copper or silver, into fine interconnect recesses provided in a surface of a substrate such as a semiconductor wafer, a conductive film having a function to prevent thermal diffusion of the interconnect material into an interlevel dielectric layer or a function to improve adhesiveness between the interconnects and an interlevel dielectric layer, or a protective film, such as magnetic film, covering interconnects.

## Claims

1. An electroless plating apparatus comprising:
a plating solution circulation system including a plating solution supply pipe for supplying a plating solution in a plating solution reservoir tank to a plating tank, and a plating solution recovery pipe for returning the plating solution in the plating tank to the plating solution reservoir tank; and
a heat retention section for preventing lowering of the temperature of the plating solution in the entire plating solution circulation system.

2. The electroless plating apparatus according to claim 1, wherein the heat retention section is comprised of a heat insulating material provided in substantially the entire area of the plating solution circulation system.

3. The electroless plating apparatus according to claim 1, wherein the heat retention section is provided in substantially the entire area of the plating solution recovery pipe.

4. The electroless plating apparatus according to claim 1, wherein the heat retention section is comprised of a double pipe composed of the plating solution supply pipe as an inner pipe, and the plating solution recovery pipe as an outer pipe concentrically surrounding the plating solution supply pipe.

5. An electroless plating apparatus comprising:
a pure water replenishment pipe for supplying pure water to a plating solution in a plating solution reservoir tank storing the plating solution to be supplied to a plating tank; and
a preheating section for preheating pure water to be supplied to the pure water replenishment pipe or pure water flowing along the pure water replenishment pipe.

6. The electroless plating apparatus according to claim 5, wherein a front end of the pure water replenishment pipe is connected to a heat exchange pipe disposed in the plating solution in the plating solution reservoir tank.

7. A plating solution comprising boric acid as a buffer and citric acid as a complexing agent, and having a temperature of 60 to 95°C, a pH of 7 to 9.8, and a boric acid concentration of 5 to 20 g/L in terms of orthoboric acid.

8. The plating solution according to claim 7 further comprising phosphinic acid in a concentration of 0.1 to 0.5 mol/L and tungstic acid in a concentration of 0.004 to 0.1 mol/L in terms of tungsten.

9. The plating solution according to claim 7 further comprising a cobalt ion in a concentration of 0.01 to 0.13 mol/L, and has a citric acid concentration of 0.1 to 0.5 mol/L.

10. The plating solution according to claim 9 further comprising phosphinic acid in a concentration of 0.1 to 0.5 mol/L and tungstic acid in a concentration of 0.004 to 0.1 mol/L in terms of tungsten.
